# EUROPÄISCHE PATENTSCHRIFT

(11) **EP 3 350 848 B1**
(45) Veröffentlichungstag und Bekanntmachung des Hinweises auf die Patenterteilung: **05.06.2019**
(21) Anmeldenummer: 16765985.3
(22) Anmeldetag: 14.09.2016
(51) Int. Cl.: H01L 35/32, D03D 1/00, H01L 35/08

(54) **THERMOELEKTRISCHE VORRICHTUNG, INSBESONDERE FÜR EINE KLIMATISIERUNGSANLAGE EINES KRAFTFAHRZEUGS**
THERMOELECTRIC DEVICE, IN PARTICULAR FOR AN AIR CONDITIONING SYSTEM OF A MOTOR VEHICLE
DISPOSITIF THERMOÉLECTRIQUE, NOTAMMENT POUR UNE INSTALLATION DE CLIMATISATION D'UN VÉHICULE À MOTEUR

(30) Priorität: 16.09.2015 DE 102015217754
(43) Veröffentlichungstag der Anmeldung: 25.07.2018
(73) Patentinhaber: Mahle International GmbH, 70376 Stuttgart (DE)
(72) Erfinder: GRÜNWALD, Jürgen, 71638 Ludwigsburg (DE); NEUMEISTER, Dirk, 70374 Stuttgart (DE)
(74) Vertreter: BRP Renaud & Partner mbB Rechtsanwälte Patentanwälte Steuerberater
(86) Internationale Anmeldenummer: PCT/EP2016/071714
(87) Internationale Veröffentlichungsnummer: WO 2017/046174

(56) Entgegenhaltungen:
- WO-A1-2014/064455
- WO-A1-2015/066518
- WO-A2-2008/104312
- JP-A- H 109 969
- US-A- 3 019 278
- US-A1- 2004 025 930
- US-A1- 2012 060 885

## Beschreibung

Die Erfindung betrifft eine thermoelektrische Vorrichtung, insbesondere für eine Klimatisierungsanlage eines Kraftfahrzeugs, sowie eine Klimatisierungsanlage mit wenigstens einer solchen thermoelektrischen Vorrichtung.

Kraftfahrzeuge besitzen im Fahrzeuginnenraum eine Vielzahl von Oberflächen, die aufgrund ihrer hohen Oberflächentemperatur den Fahrzeuginnenraum stark aufheizen, wenn das Fahrzeug längeren Zeitraum hinweg einer intensiven Sonnenbestrahlung ausgesetzt ist. Besagte Oberflächen müssen daher von einer Klimatisierungsanlage des Kraftfahrzeugs zunächst zumindest oberflächlich gekühlt werden, um für die Insassen des Kraftfahrzeugs akzeptable Umgebungsbedingungen herzustellen. Wünschenswert ist daher eine Technologie, welche bereits in den ersten Sekunden nach Inbetriebnahme der Klimatisierungsanlage eine schnelle Abkühlung der Oberflächen des Fahrzeuginterieurs bewirkt.

In herkömmlichen Kraftfahrzeugen wird die Kühlung des Innenraumes ausschließlich mittels Verdampfungskühlung durch Übertragung von Kälte an in den Innenraum strömende Luft bewerkstelligt. Warme Oberflächen, die in den Innenraum abstrahlen, werden somit erst allmählich, durch konvektiven Übergang von Wärme an die strömende Luft, abgekühlt.

Lediglich für Flächen mit direktem Kontakt zu den Insassen existieren Vorrichtungen mit geringer Kühlzeit: So ist aus dem Stand der Technik für Fahrzeuge der Oberklasse eine aktive Sitzkühlung bekannt, bei welcher in den Sitz einströmende Luft über Peltier-Element aktiv gekühlt wird und über porenartige Öffnungen über der Sitzoberfläche zum Insassen hin ausströmt. Ein solches Peltier-Element besitzt p- und n-dotierte Halbleiter, die abwechselnd und elektrisch in Reihe zueinander angeordnet sind. Elektrisch leitende Kontaktbrücken zwischen den dotierten Bereichen dienen als Wärmeaufnahme- bzw. Wärmeabgabeelement. Sie sind, um eine Heißseite thermisch und räumlich von einer Kaltseite zu trennen, abwechselnd auf einer Ober- bzw. einer Unterseite des Peltier-Elements angebracht.

Die DE 195 03 291 C2 offenbart eine Heizungs-Kühlmatte für einen Fahrzeugsitz. Diese umfasst eine Klimatisierungsmatte, in welcher mehrere Peltier-Elemente angeordnet sind, die zur Spannungsversorgung an ein elektrisches Bordnetz eines Kraftfahrzeugs angeschlossen werden können.

Die DE 10 2012 018 387 A1 behandelt einen thermoelektrischen Generator mit einem thermoelektrischen Substrat und einer Vielzahl von Thermopaaren, wobei jedes Thermopaar einen ersten thermoelektrischen Leiter aus einem ersten thermoelektrischen Aktivmaterial und einen zweiten thermoelektrischen Leiter aus einem zweiten thermoelektrischen Aktivmaterial aufweist.

Die DE 10 2013 110 254 A1 behandelt ein thermoelektrisches Element, welches elektrisch leitende Fäden, Fadenbüschel oder Filamente umfasst. Diese sind durch einen Träger hindurch in Form von Leitsträngen ausgebildet.

Die EP 1 340 060 B1 behandelt ein Verfahren zum Herstellen thermoelektrischer Umwandler mit mehreren, in Serie angeordneten thermoelektrischen Elementen. Diese werden durch Verweben von elektrisch leitenden Drähten aus zwei unterschiedlichen Materialien, die parallel und abwechselnd angeordnet sind, mit Drähten aus elektrisch isolierendem Material ausgebildet.

Die US 2012/0060885 A1 offenbart eine thermoelektrische Vorrichtung mit einer Mehrzahl von elektrisch leitenden ersten Fäden und mit einer Mehrzahl von elektrisch isolierenden zweiten Fäden, die zusammen ein Gewebe ausbilden, wobei zur Ausbildung des Gewebes als thermoelektrisch aktives Gewebe in wenigstens einem ersten Faden abwechselnd eine Mehrzahl von p-dotierten und n-dotierten Fadenabschnitten vorhanden ist.

Nachteilig bei der Verwendung von herkömmlichen Peltier-Elementen zur aktiven Kühlung eines Fahrzeuginnenraums erweist sich, dass diese nicht für die Kühlung großflächiger Oberflächen geeignet sind.

Der vorliegenden Erfindung liegt die Aufgabe zugrunde, eine thermoelektrische Vorrichtung zu schaffen, die sich zur Kühlung aufgeheizter Flächen mit großer Oberfläche, insbesondere im Fahrzeuginnenraum eines Kraftfahrzeugs, eignet. Diese Aufgabe wird erfindungsgemäß durch die Gegenstände der unabhängigen Patentansprüche gelöst. Vorteilhafte Weiterbildungen sind Gegenstand der abhängigen Patentansprüche.

Grundgedanke der Erfindung ist demnach, eine thermoelektrische als Gewebe mit elektrisch leitenden und thermoelektrisch aktiven Kettfäden und mit elektrisch isolierenden Schussfäden auszubilden, oder umgekehrt. Dies ermöglicht eine Ausbildung der thermoelektrischen Vorrichtung als flexibles Flächengebilde, welches großflächig als Teil einer Kühlvorrichtung in einer Klimatisierungsanlage eingesetzt werden kann.

Eine erfindungsgemäße thermoelektrische Vorrichtung umfasst eine Mehrzahl von elektrisch leitenden ersten Fäden und eine Mehrzahl von elektrisch isolierenden zweiten Fäden, die zusammen ein Gewebe ausbilden. Die ersten Fäden können Kettfäden des Gewebes sein, und die zweiten Fäden können Schussfäden des Gewebes sein, oder umgekehrt. Zur thermoelektrisch aktiven Ausbildung des Gewebes ist in wenigstens einem ersten Faden abwechselnd eine Mehrzahl von p-dotierten und n-dotierten Fadenabschnitten vorhanden. Bevorzugt gilt dies für mehrere, also für wenigstens erste Fäden, besonders bevorzugt für alle ersten Fäden des Gewebes. Die elektrisch leitfähigen ersten Fäden dabei bilden nicht nur ein thermoelektrisch aktives Element, sondern dabei - je nach Lage relativ zu den elektrisch isolierenden zweiten Fäden - abschnittsweise auch jeweils eine Heißseite oder eine Kaltseite der thermoelektrischen Vorrichtung ausbilden. Vom Begriff "Gewebe" seien vorliegend Realisierungsformen, die dem Fachmann im Fachbereich Textiltechnik unter den Bezeichnungen "Leinwandbindung", "Körperbindung" sowie "Atlasbindung" bekannt sind, ausdrücklich umfasst. Bevorzugt sind die zweiten Fäden thermisch isolierend ausgebildet. Auf diese Weise können unerwünschte Wärmebrücken zwischen der Heißseite und der Kaltseite unterbunden werden.

Die im Gewebe angeordneten ersten Fäden weisen einen wellenartigen Verlauf mit einer Mehrzahl von Krümmungs-Wendepunkten auf, wobei die p- und n-dotierten Fadenabschnitte im Bereich eines jeweiligen Krümmungs-Wendepunkts des ersten Fadens angeordnet sind. Nicht-dotierte Bereiche zwischen den Fadenabschnitten können dann als Heißseite bzw. Kaltseite fungieren.

Bei einer weiteren bevorzugten Ausführungsform ist das Gewebe als Flächengebilde ausgebildet. Dies ermöglicht eine großflächige Verwendung des Gewebes auf nicht-ebenen Flächen, wie sie im Innenraum eines Kraftfahrzeugs vielfach vorhanden sind.

Um in der erfindungsgemäßen thermoelektrische Vorrichtung einen möglichst hohen Wirkungsgrad zu erzielen, sind die p-dotierten und die n-dotierten Fadenabschnitte in einer weiteren bevorzugten Ausführungsform derart in den ersten Fäden angeordnet, dass eine erste Seite des Gewebe eine Heißseite und eine der erste Seite gegenüberliegende, zweite Seite des Gewebes eine Kaltseite ausbildet, oder umgekehrt.

Bei einer vorteilhaften Weiterbildung der Erfindung weisen die ersten Fäden jeweils einen elektrisch leitenden Leiter, vorzugsweise aus einem Metall, besonders bevorzugt aus Kupfer, auf, der von einer elektrisch isolierenden Hülle umgeben ist. Bevorzugt besteht die Hülle aus Kunststoff. Auf diese Weise können unerwünschte elektrische Kurzschlüsse einzelner elektrisch leitender ersten Fäden untereinander oder mit anderen elektrisch leitenden Materialen, die in der Umgebung des Gewebes vorhanden sein können, ausgeschlossen werden.

Bei einer anderen bevorzugten Ausführungsform sind die ersten Fäden und/oder die zweiten Fäden bandartig ausgebildet. Eine solche, flächige Ausbildung der ersten bzw. zweiten Fäden erhöht die von diesen bereitstellbare Kühlleistung, insbesondere bei Verwendung in einer Klimatisierungsanlage.

Besonders zweckmäßig erstrecken sich die einzelnen ersten Fäden entlang einer ersten Richtung, wohingegen sich die zweiten Fäden sich entlang einer zweiten Richtung erstrecken, die quer zur ersten Richtung verläuft.

Bei einer weiteren bevorzugten Ausführungsform sind alle vorhandenen ersten Fäden elektrisch in Reihe zueinander geschaltet. Dies verringert den Verdrahtungsaufwand beim Anschließen der ersten Fäden an eine elektrische Spannungsquelle. Daraus wiederum ergeben sich erhebliche Kosteneinsparungen bei der Herstellung der thermoelektrischen Vorrichtung.

Bei einer vorteilhaften Weiterbildung können alle vorhandenen ersten Fäden integral aneinander ausgeformt sein. Der sich ergebende Gesamt-Faden ist besonders kostengünstig herzustellen und besonders einfach mit den zweiten Fäden zu einem Gewebe zu verarbeiten. Des Weiteren müssen bei dieser Variante nicht alle ersten Fäden einzeln zum Anschließen an eine elektrische Spannungsquelle ausgebildet werden, sondern vielmehr ist es ausreichend, den Gesamt-Faden mit seinen beiden Enden mit einer solchen elektrischen Spannungsquelle zu verbinden. Daraus ergeben sich ebenfalls reduzierte Herstellungskosten.

Bei einer vorteilhaften Weiterbildung ist es denkbar, eine elektrische Reihenschaltung und eine elektrische Parallelschaltung der ersten Fäden miteinander zu kombinieren.

Besonders zweckmäßig können die vorhandenen ersten Fäden in einer Draufsicht auf die erste und/oder zweite Seite des Gewebes mäanderartig angeordnet sein. Auf diese Weise kann sichergestellt werden, dass auf der Kaltseite flächig eine homogene Kühlleistung erzielt wird.

Bei einer anderen bevorzugten Ausführungsform können wenigstens zwei, vorzugsweise alle, ersten Fäden elektrisch parallel zueinander verschaltet sein. Auf diese Weise lässt sich die Höhe der zum Betrieb der ersten Fäden als thermoelektrische Vorrichtung - insbesondere gegenüber einer elektrischen Reihenschaltung - erforderliche elektrische Versorgungsspannung verringern.

Da das Gewebe der thermoelektrischen Vorrichtung selbst nur eine relativ geringe thermische Kapazität aufweist, kann es bei loser Platzierung nur für kurze Zeit einen thermischen Abkühlungseffekt auf der Kaltseite erzeugen. Besonders zweckmäßig kann daher auf der Heißseite ein zusätzlicher Wärmespeicher zur Zwischenspeicherung von Wärme angeordnet sein, der zur thermischen Kopplung an den ersten Fäden anliegt. Besagter Wärmespeicher dient dazu, an der Heißseite bereitgestellte Wärme aufzunehmen und temporär zwischen zu speichern.

Besonders bevorzugt kann der Wärmespeicher als Wärmespeicherplatte ausgebildet sein, die mittels eines thermisch leitenden Adhäsionsmittels an den ersten Fäden befestigt ist. Die erlaubt eine Flächige Anbindung des Wärmespeichers an die Heißseite der thermoelektrischen Vorrichtung. Vorzugsweise ist das thermisch leitende Adhäsionsmittel ein Klebstoff.

Besonders zweckmäßig kann der Wärmespeicher ein mechanisch flexibles Material aufweisen. Auf diese Weise kann die gewünschte mechanische und thermische Anbindung an das Gewebe der thermoelektrischen Vorrichtung auch bei einer nicht vollständig ebenen Ausbildung des Gewebes sichergestellt werden.

Als technisch besonders einfach und somit kostengünstig zu realisieren erweist sich eine weitere bevorzugte Variante, bei welcher der Wärmespeicher eine flexible Hülle, vorzugsweise aus einem Metall, besonders bevorzugt eine Metallfolie, aufweist. Bei dieser Variante ist in der flexiblen Hülle eine Flüssigkeit oder ein PCM-Material zur Aufnahme der zu speichernden Wärme angeordnet.

Bei einer weiteren bevorzugten Ausführungsform kann eine Hüllendicke der elektrisch isolierenden Hülle zumindest eines ersten Fadens in zumindest einem Übergangsbereich zwischen einem p- oder n-dotierten Fadenabschnitt und dem dazu benachbarten Fadenabschnitt ohne Dotierung zum Zwecke der Zugentlastung erhöht sein. Auf diese Weise wird die Festigkeit des betreffenden ersten Fadens, insbesondere bei Belastung auf Zug, deutlich verbessert.

Bei einer anderen bevorzugten Ausführungsform kann in zumindest einem ersten Faden in zumindest einem Übergangsbereich zwischen einem p- oder n-dotierten Fadenabschnitt und dem dazu benachbarten Fadenabschnitt ohne Dotierung eine, insbesondere zusätzliche, Umhüllung zur Zugentlastung vorgesehen sein. "Zusätzlich" bedeutet, dass diese Umhüllung zusätzlich zur oben beschriebenen elektrisch isolierenden Hülle vorgesehen werden kann. Auch auf diese Weise wird die Festigkeit des betreffenden ersten Fadens, insbesondere bei Belastung auf Zug, verbessert. Eine solche "zusätzliche Umhüllung" kann auch vorgesehen werden, wenn auf die elektrisch isolierende Hülle verzichtet ist.

In einer Variante der Erfindung können die ersten Fäden und zweiten Fäden des Gewebes vertauscht sein, d.h. in einem solchen Szenario besitzen die ersten Fäden die Eigenschaften der vorangehend beschriebenen zweiten Fäden und die zweiten Fäden die Eigenschaften der oben beschriebenen ersten Fäden.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch,
- Fig. 1: den prinzipiellen Aufbau einer thermoelektrischen Vorrichtung mit thermoelektrisch aktiven Elementen,
- Fig. 2/3: den prinzipiellen Aufbau eines Gewebes mit Kettfäden und Schussfäden in einer Draufsicht bzw. Seitenansicht,
- Fig. 4: ein Beispiel einer erfindungsgemäßen thermoelektrischen Vorrichtung,
- Fig. 5: eine Weiterbildung der thermoelektrischen Vorrichtung der Figur 4,
- Fig. 6: ein erstes Beispiel für eine mögliche elektrische Verdrahtung der Kettfäden der thermoelektrischen Vorrichtung,
- Fig. 7: ein zweites Beispiel einer möglichen elektrischen Verdrahtung der Kettfäden der thermoelektrischen Vorrichtung,
- Fig. 8: eine schematische Darstellung eines mit der thermoelektrische Vorrichtung zusammenwirkenden Wärmespeichers,
- Fig. 9: eine Weiterbildung des Beispiels der Figur 5 in einer Detaildarstellung.

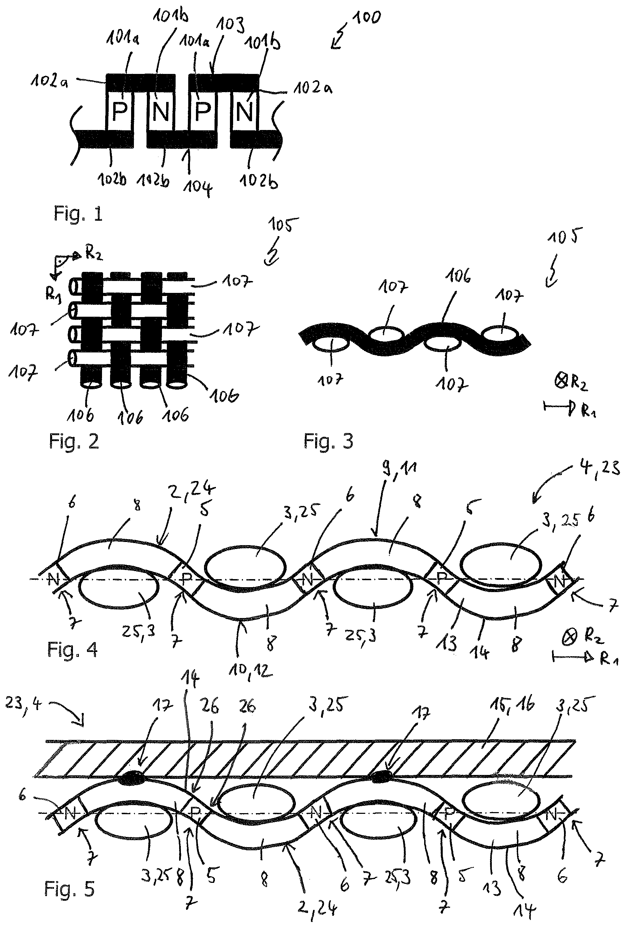

Figur 1 illustriert den prinzipiellen Aufbau eines herkömmlichen thermoelektrischen Elements 100. Dieses umfasst eine Mehrzahl von p- und n-dotierten elektrischen Halbleitern 101a, 101b, die abwechselnd elektrisch in Reihe miteinander kontaktiert sind. Die elektrische Kontaktierung erfolgt mittels erster elektrischer Brücken 102a, die gleichzeitig eine Heißseite 103 des thermoelektrischen Elements 100 ausbilden, sowie mittels zweiter elektrischer Brücken 102b, die eine Kaltseite 104 des thermoelektrischen Elements 100 ausbilden und den ersten elektrischen Brücken 102a gegenüberliegen.

Die Figuren 2 und 3 illustrieren den prinzipiellen Aufbau eines herkömmlichen Gewebes 105 in einer Draufsicht bzw. Seitenansicht. Entsprechend Figur 2 weist das Gewebe 105 eine Mehrzahl von Kettfäden 106 auf, die sich parallel zueinander entlang einer ersten Richtung R₁ erstrecken. Eine Mehrzahl von Schussfäden 107 erstreckt sich parallel zueinander entlang einer zweiten Richtung R₂, die senkrecht oder zumindest im Wesentlichen senkrecht zur ersten Richtung R₁ verläuft. Die Kettfäden 106 sind mit den Schussfäden 107 durch die Verbindungsart "Fadenverkreuzung" verbunden. Dies bedeutet, dass sich die Kettfäden 106 in einem bestimmten Rhythmus, dem einschlägigen Fachmann als "Bindung" bekannt, abwechselnd über und unter den querliegenden Schussfäden 107 erstrecken. Entsprechend erstrecken sich die Schussfäden 107 abwechselnd über und unter den querliegenden Kettfäden 106.

Die Figur 4 zeigt nun ein Beispiel einer erfindungsgemäßen thermoelektrischen Vorrichtung 1 in einem Querschnitt. Die thermoelektrische Vorrichtung 1 umfasst eine Mehrzahl von ersten Fäden 24 in Form von elektrisch leitenden Kettfäden 2 und eine Mehrzahl von zweiten Fäden 25 in Form von elektrisch isolierenden Schussfäden 3, die zusammen ein Gewebe 4 ausbilden. Die Anordnung der Kettfäden und Schussfäden 2, 3 entspricht dabei der anhand der Figuren 2 und 3 für ein herkömmliches Gewebe 105 erläuterten Anordnung der Kettfäden und Schussfäden 106, 107. Die Figur 4 zeigt das Gewebe 4 der erfindungsgemäßen thermoelektrischen Vorrichtung 1 also in einer Darstellung, welche jener der Figur 3 für das herkömmliche Gewebe 105 entspricht. In Figur 4 ist daher nur ein einziger Kettfaden 2 dargestellt, der sich entlang einer ersten Richtung R₁ erstreckt. Weiterhin sind exemplarisch vier Schussfäden 3 gezeigt, die sich entlang einer zweiten Richtung R₂ erstrecken, die senkrecht zur ersten Richtung R₁ -im Beispiel der Figur 4 senkrecht zur Zeichenebene - verläuft.

Zur Ausbildung des Gewebes 4 als thermoelektrisch aktives Element ist in jedem Kettfaden 2 abwechselnd eine Mehrzahl von p-dotierten Fadenabschnitten 5 und n-dotierten Fadenabschnitten 6 angeordnet. Das Gewebe 4 ist vorzugsweise als Flächengebilde 23 ausgebildet.

Entsprechend Figur 4 besitzt der Kettfaden 2 im Gewebe 4 einen wellenartigen Verlauf mit einer Mehrzahl von Krümmungs-Wendepunkten 7. Erfindungsgemäß sind die p- und n-dotierten Fadenabschnitte 5, 6 in einem jeweiligen Krümmungs-Wendepunkt 7 angeordnet. Benachbarte Fadenabschnitte 5, 6 sind vorzugsweise im Abstand zueinander angeordnet, so dass zwischen zwei benachbarten Fadenabschnitten 5, 6 mit p- oder n-Dotierung jeweils ein Fadenabschnitt 8 ohne Dotierung vorgesehen sein kann. Diese Fadenabschnitte 8 entsprechen den bereits im Zusammenhang mit Figur 1 gezeigten ersten und zweiten elektrischen Brücken 102a, 102b.

Die p-dotierten und die n-dotierten Fadenabschnitte 5, 6 sind derart in den Kettfäden 2 angeordnet, dass eine erste Seite 9 des Gewebes 4 eine Heißseite 11 und eine der erste Seite 9 gegenüberliegende zweite Seite 10 des Gewebes 4 eine Kaltseite 12 ausbildet (vgl. Figur 4) oder umgekehrt (in den Figuren nicht gezeigt). Die Fadenabschnitte 8 wirken als Heißseite oder Kaltseite der thermoelektrischen Vorrichtung 1, je nachdem, auf welcher Seite sie relativ zu den Schussfäden 3 angeordnet sind.

Ein Kettfaden 2 besitzt einen elektrisch leitenden Leiter 13, der von einer elektrisch isolierenden Hülle 14 umgeben ist. Auf diese Weise können unerwünschte elektrische Kurzschlüsse der elektrisch leitenden Kettfäden 2 mit anderen elektrisch leitenden Materialen in der Umgebung des Gewebes 4 oder untereinander ausgeschlossen werden. Der elektrische Leiter 13 ist bevorzugt ein Metall wie beispielsweise Kupfer. Die Hülle besteht bevorzugt aus einem Kunststoff oder umfasst einen solchen Kunststoff. Eine Hüllendicke der elektrisch isolierende Hülle 14 kann in Übergangsbereich 26 zwischen einem p- oder n-dotierten Fadenabschnitt 5, 6 und dem dazu benachbarten Fadenabschnitt 8 ohne Dotierung zum Zwecke der Zugentlastung erhöht sein.

Die Schussfäden 3 sind vorzugsweise nicht nur elektrisch isolierend, sondern auch thermisch isolierend ausgebildet. Auf diese Weise können unerwünschte Wärmebrücken zwischen der Heißseite 11 und der Kaltseite 12 unterbunden werden. In einer in den Figuren nicht gezeigten Variante können die Kettfäden 2 und/oder die Schussfäden 3 zur Erhöhung der Wärmeübertragungsleistung auch bandartig ausgebildet sein. Die elektrisch isolierenden Schussfäden 3 können aus einem Kunststoff bestehen.

Die Figur 5 zeigt eine Weiterbildung der thermoelektrischen Vorrichtung 1 der Figur 1. Bei der Variante gemäß Figur 5 ist auf der Heißseite ein Wärmespeicher zur Zwischenspeicherung von Wärme angeordnet, der zur thermischen Kopplung an den Kettfäden 2 anliegt. Der Wärmespeicher 15 kann plattenartig als Wärmespeicherplatte 16 ausgebildet sein, die mittels eines thermisch leitenden Adhäsionsmittels 17, beispielsweise eines wärmeübertragenden Klebstoffs, an den Kettfäden 2 befestigt ist.

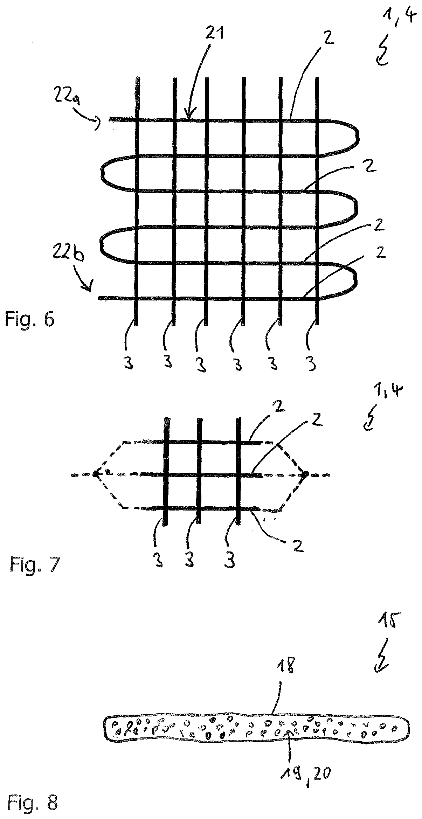

Bevorzugt umfasst Wärmespeicher 15 bzw. die Wärmespeicherplatte 16 ein mechanisch flexibles Material. In Figur 8 ist schematisch eine mögliche technische Realisierungsform eines solchen, mechanisch flexiblen Wärmespeichers 15 gezeigt. Dieser besitzt eine flexible Hülle 18, vorzugsweise aus einem Metall, in welcher eine Flüssigkeit 19 oder ein PCM-Material 20 zur Zwischenspeicherung der Wärme angeordnet ist. Besonders bevorzugt kann die Hülle 18 als Metallfolie ausgebildet sein.

In Figur 6 ist eine mögliche Anordnung der Kettfäden 2 und der Schussfäden 3 in einer Draufsicht auf die Heißseite 11 (ein optional vorhandener Wärmespeicher 15 ist in Figur 6 nicht dargestellt). Wie Figur 6 erkennen lässt, sind alle vorhandenen Kettfäden 2 integral aneinander ausgeformt und auf diese Weise elektrisch in Reihe zueinander geschaltet. Der sich ergebende Gesamt-Faden 21 weist einen ersten Endabschnitt 22a und einen dem ersten Endabschnitt 22a gegenüberliegenden zweiten Endabschnitt 22b auf, die beide an eine elektrischen Spannungsversorgung (in Figur 6 nicht gezeigt) angeschlossen werden können. Die den Gesamt-Faden 21 bildenden Kettfäden 2 sind in der in Figur 6 gezeigten Draufsicht auf die erste Seite 9 bzw. auf die Heißseite 11 des Gewebes 4 mäanderartig angeordnet. Die einzelnen Kettfäden 2 sind bei dieser Variante elektrisch zueinander in Reihe geschaltet, so dass zum Betrieb der thermoelektrischen Vorrichtung 1 nur die beiden Endabschnitte 22a, 22b an eine elektrische Spannungsversorgung angeschlossen werden müssen.

Demgegenüber zeigt die Figur 7 eine Variante der Anordnung der Figur 6, bei alle vorhandenen Kettfäden 2 elektrisch parallel zueinander verschaltet sind.

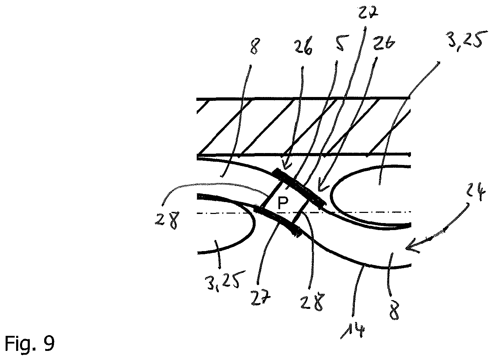

Die Figur 9 zeigt eine Weiterbildung der thermoelektrischen Vorrichtung 1 der Figur 5. Demnach kann im Übergangsbereich 26 des ersten Fadens 24 zwischen einem p- oder n-dotierten Fadenabschnitt 5, 6 - die Figur 9 zeigt exemplarisch eine p-Dotierung - und dem dazu benachbarten Fadenabschnitt 8 eine zusätzliche Umhüllung 27 zur Zugentlastung des ersten Fadens 24 vorgesehen sein. Die Umhüllung 27 kann zusätzlich zur elektrisch isolierenden Hülle 14 vorgesehen sein und sich wie in Figur 9 gezeigt über den gesamten p-dotierten Fadenabschnitt 6 hinweg erstrecken. Die zusätzliche Umhüllung 27 steht also in den Fadenabschnitt 8 ohne Dotierung über, so dass die Grenzflächen 28 zwischen p-bzw. der n-dotiertem Fadenabschnitt 5, 6 und dem Fadenabschnitt 8 ohne Dotierung entlastet werden.

## Patentansprüche

1. Thermoelektrische Vorrichtung (1), insbesondere für eine Klimatisierungsanlage eines Kraftfahrzeugs,
mit einer Mehrzahl von elektrisch leitenden ersten Fäden (24) und mit einer Mehrzahl von elektrisch isolierenden zweiten Fäden (25), die zusammen ein Gewebe (4) ausbilden,
wobei zur Ausbildung des Gewebes (4) als thermoelektrisch aktives Gewebe in wenigstens einem ersten Faden (24), vorzugsweise in allen ersten Fäden (24) (24), abwechselnd eine Mehrzahl von p-dotierten und n-dotierten Fadenabschnitten (5, 6) vorhanden ist,
**dadurch gekennzeichnet, dass**
die ersten Fäden (24) im Gewebe einen wellenartigen Verlauf mit einer Mehrzahl von Krümmungs-Wendepunkten (7) aufweisen, wobei die p- und n-dotierten Fadenabschnitte (5, 6) in einem jeweiligen Krümmungs-Wendepunkt (7) des ersten Fadens (24) angeordnet sind.

2. Thermoelektrische Vorrichtung nach Anspruch 1,
**dadurch gekennzeichnet, dass**
die zweiten Fäden (25) thermisch isolierend ausgebildet sind.

3. Thermoelektrische Vorrichtung nach Anspruch 1 oder 2,
**dadurch gekennzeichnet, dass**
die ersten Fäden (24) als Kettfäden (2) und die zweiten Fäden (25) als Schuss-. fäden (3) des Gewebes (4) ausgebildet sind, oder umgekehrt.

4. Thermoelektrische Vorrichtung nach einem der vorhergehenden Ansprüche,
**dadurch gekennzeichnet, dass**
die p-dotierten und die n-dotierten Fadenabschnitte (5, 6) derart in den ersten Fäden (24) angeordnet sind, dass eine erste Seite (9) des Gewebe (4) eine Heißseite (11) und eine der ersten Seite (9) gegenüberliegende zweite Seite (10) des Gewebes (4) eine Kaltseite (12) ausbildet, oder umgekehrt.

5. Thermoelektrische Vorrichtung nach einem der vorhergehenden Ansprüche,
**dadurch gekennzeichnet, dass**
die ersten Fäden (24) jeweils einen elektrisch leitenden Leiter (13), insbesondere aus einem Metall, aufweisen, der von einer elektrisch isolierenden Hülle (14), insbesondere aus einem Kunststoff, umgeben ist.

6. Thermoelektrische Vorrichtung nach einem der vorhergehenden Ansprüche,
**dadurch gekennzeichnet, dass**
die ersten Fäden (24) und/oder die zweiten Fäden (25) bandartig ausgebildet sind.

7. Thermoelektrische Vorrichtung nach einem der vorhergehenden Ansprüche
**dadurch gekennzeichnet, dass**
alle vorhandenen ersten Fäden (24) elektrisch in Reihe zueinander geschaltet sind.

8. Thermoelektrische Vorrichtung nach einem der vorhergehenden Ansprüche
**dadurch gekennzeichnet, dass**
die ersten Fäden (24) integral aneinander ausgeformt sind.

9. Thermoelektrische Vorrichtung nach einem der vorhergehenden Ansprüche,
**dadurch gekennzeichnet, dass**
die ersten Fäden (24) in einer Draufsicht auf die erste oder zweite Seite (9, 10) des Gewebes (4) mäanderartig angeordnet sind.

10. Thermoelektrische Vorrichtung nach einem der vorhergehenden Ansprüche,
**dadurch gekennzeichnet, dass**
wenigstens zwei erste Fäden (24), vorzugsweise alle vorhandenen ersten Fäden (24), elektrisch parallel zueinander verschaltet sind.

11. Thermoelektrische Vorrichtung nach einem der Ansprüche 5 bis 10,
**dadurch gekennzeichnet, dass**
auf der Heißseite (11) ein Wärmespeicher (15) zur Zwischenspeicherung von Wärme angeordnet ist, der zur thermischen Kopplung an den ersten Fäden (24) anliegt.

12. Thermoelektrische Vorrichtung nach Anspruch 11,
**dadurch gekennzeichnet, dass**
der Wärmespeicher (15) als Wärmespeicherplatte (16) ausgebildet ist, die mittels eines thermisch leitenden Adhäsionsmittels (17) mit den ersten Fäden (24) verbunden ist.

13. Thermoelektrische Vorrichtung nach Anspruch 11 oder 12,
**dadurch gekennzeichnet, dass**
der Wärmespeicher (15) ein mechanisch flexibles Material aufweist.

14. Thermoelektrische Vorrichtung nach einem der Ansprüche 11 bis 13,
**dadurch gekennzeichnet, dass**
der Wärmespeicher (15) eine flexible Hülle (18), vorzugsweise aus einem Metall, besonders bevorzugt eine Metallfolie, aufweist, in welcher eine Flüssigkeit (19) oder ein PCM-Material (20) zur Zwischenspeicherung der Wärme angeordnet ist.

15. Thermoelektrische Vorrichtung nach einem Ansprüche 5 bis 14,
**dadurch gekennzeichnet, dass**
eine Hüllendicke der elektrisch isolierenden Hülle (14) zumindest eines ersten Fadens (24) in zumindest einem Übergangsbereich (26) zwischen einem p-oder n-dotierten Fadenabschnitt (5, 6) und dem dazu benachbarten Fadenabschnitt (8) ohne Dotierung zum Zwecke der Zugentlastung erhöht ist.

16. Thermoelektrische Vorrichtung nach einem der vorhergehenden Ansprüche,
**dadurch gekennzeichnet, dass**
in zumindest einem Übergangsbereich (26) eines ersten Fadens (24) zwischen einem p- oder n-dotierten Fadenabschnitt (5, 6) und dem dazu benachbarten Fadenabschnitt (8) zumindest eines ersten Fadens (24) eine, insbesondere zusätzliche, Umhüllung (27) zur Zugentlastung vorgesehen ist.

17. Klimatisierungsanlage mit wenigstens einer thermoelektrischen Vorrichtung (1) nach einem der vorhergehenden Ansprüche.

## Claims

1. Thermoelectric device (1), in particular for an air conditioning system of a motor vehicle,
comprising a plurality of electrically conductive first threads (24) and a plurality of electrically insulating second threads (25), which together form a woven fabric (4),
wherein a plurality of p-doped and n-doped thread segments (5, 6) is present in alternation in at least one first thread (24), preferably in all first threads (24), in order to design the woven fabric (4) as a thermoelectrically active woven fabric,
**characterised in that**
the first threads (24) in the woven fabric have a wavy course with a plurality of curvature turning points (7), wherein the p- and n-doped thread segments (5, 6) are disposed in a respective curvature turning point (7) of the first thread (24).

2. Thermoelectric device according to claim 1,
**characterised in that**
the second threads (25) are designed to be thermally insulating.

3. Thermoelectric device according to claim 1 or 2,
**characterised in that**
the first threads (24) are designed as warp threads (2) and the second threads (25) as weft threads (3) of the woven fabric (4), or vice versa.

4. Thermoelectric device according to any one of the preceding claims, **characterised in that**
the p-doped and the n-doped thread segments (5, 6) are disposed in such a way in the first threads (24), that a first side (9) of the woven fabric (4) forms a hot side (11) and a second side (10) of the woven fabric (4) lying opposite the first side (9) forms a cold side (12), or vice versa.

5. Thermoelectric device according to any one of the preceding claims, **characterised in that**
the first threads (24) each have an electrically conductive conductor (13), in particular of a metal, which is surrounded by an electrically insulating sheath (14), in particular consisting of a plastic.

6. Thermoelectric device according to any one of the preceding claims, **characterised in that**
the first threads (24) and/or the second threads (25) are formed in the manner of a tape.

7. Thermoelectric device according to any one of the preceding claims, **characterised in that**
all first threads (24) present are connected together electrically in series.

8. Thermoelectric device according to any one of the preceding claims, **characterised in that**
the first threads (24) are moulded integrally onto one another.

9. Thermoelectric device according to any one of the preceding claims, **characterised in that**
the first threads (24) in a top view are disposed in a serpentine manner onto the first or second side (9, 10) of the woven fabric (4).

10. Thermoelectric device according to any one of the preceding claims, **characterised in that**
at least two first threads (24), preferably all first threads (24) present, are interconnected electrically parallel to one another.

11. Thermoelectric device according to any one of claims 5 to 10, **characterised in that**
there is disposed on the hot side (11) a heat store (15) for the temporary storage of heat, which lies against the first threads (24) for thermal coupling.

12. Thermoelectric device according to claim 11, **characterised in that**
the heat store (15) is designed as heat storage plate (16), which is connected with the first threads (24) by means of a thermally conductive means of adhesion (17).

13. Thermoelectric device according to claim 11 or 12, **characterised in that** the heat store (15) has a mechanically flexible material.

14. Thermoelectric device according to any one of claims 11 to 13, **characterised in that**
the heat store (15) has a flexible sheath (18), preferably of a metal, particularly preferably a metal foil, in which a fluid (19) or a PCM material (20) is disposed for temporary storage of the heat.

15. Thermoelectric device according to any one of claims 5 to 14, **characterised in that**
a sheath thickness of the electrically insulating sheath (14) of at least one first thread (24) is increased in at least one transitional region (26) between a p- or n-doped thread segment (5, 6) and the adjacent thread segment (8) without doping for the purpose of strain relief.

16. Thermoelectric device according to any one of the preceding claims, **characterised in that**
a, particularly additional, sheathing (27) for strain relief is provided in at least one transitional region (26) of a first thread (24) between a p- or n-doped thread segment (5, 6) and the adjacent thread segment (8) of at least one first thread (24).

17. Air conditioning system comprising at least one thermoelectric device (1) according to any one of the preceding claims.

## Revendications

1. Dispositif thermoélectrique (1), en particulier pour une installation de climatisation d'un véhicule automobile,
avec une multiplicité de premiers fils (24) électriquement conducteurs et avec une multiplicité de deuxièmes fils (25) électriquement isolants, qui réalisent ensemble un tissu (4),
dans lequel, pour réaliser le tissu (4) comme tissu actif au niveau thermoélectrique, il y a en alternance dans au moins un premier fil (24), de préférence dans tous les premiers fils (24), une multiplicité de tronçons de fils (5, 6) dopés p et dopés n,
**caractérisé en ce que**
les premiers fils (24) présentent dans le tissu une allure ondulée avec une multiplicité de points d'inflexion de courbure (7), les tronçons de fils (5, 6) dopés p et n étant agencés dans un point d'inflexion de courbure (7) respectif du premier fil (24).

2. Dispositif thermoélectrique selon la revendication 1,
**caractérisé en ce que**
les deuxièmes fils (25) sont réalisés thermiquement isolants.

3. Dispositif thermoélectrique selon la revendication 1 ou 2,
**caractérisé en ce que**
les premiers fils (24) sont réalisés comme des fils de chaîne (2) et les deuxièmes fils (25) comme des fils de trame (3) du tissu (4), ou inversement.

4. Dispositif thermoélectrique selon l'une quelconque des revendications précédentes,
**caractérisé en ce que**
les tronçons de fils (5, 6) dopés p et dopés n sont agencés de telle manière dans les premiers fils (24) qu'un premier côté (9) du tissu (4) réalise un côté chaud (11) et un deuxième côté (10), opposé au premier côté (9), du tissu (4) réalise un côté froid (12), ou inversement.

5. Dispositif thermoélectrique selon l'une quelconque des revendications précédentes,
**caractérisé en ce que**
les premiers fils (24) présentent à chaque fois un conducteur (13) électriquement conducteur, en particulier en un métal, qui est entouré par une gaine (14) électriquement isolante, en particulier en un plastique.

6. Dispositif thermoélectrique selon l'une quelconque des revendications précédentes,
**caractérisé en ce que**
les premiers fils (24) et/ou les deuxièmes fils (25) sont réalisés en forme de bande.

7. Dispositif thermoélectrique selon l'une quelconque des revendications précédentes,
**caractérisé en ce que**
tous les premiers fils (24) présents sont branchés électriquement en série les uns avec les autres.

8. Dispositif thermoélectrique selon l'une quelconque des revendications précédentes,
**caractérisé en ce que**
les premiers fils (24) sont formés de manière intégrée les uns à côté des autres.

9. Dispositif thermoélectrique selon l'une quelconque des revendications précédentes,
**caractérisé en ce que**,
dans une vue de dessus, les premiers fils (24) sont agencés en forme de méandres sur le premier ou deuxième côté (9, 10) du tissu (4).

10. Dispositif thermoélectrique selon l'une quelconque des revendications précédentes,
**caractérisé en ce que**
au moins deux premiers fils (24), de préférence tous les premiers fils (24) présents, sont branchés électriquement en parallèle les uns avec les autres.

11. Dispositif thermoélectrique selon l'une quelconque des revendications 5 à 10,
**caractérisé en ce que**
sur le côté chaud (11) est agencé un accumulateur de chaleur (15) qui est destiné à stocker temporairement de la chaleur et qui est adjacent aux premiers fils (24) en vue du couplage thermique.

12. Dispositif thermoélectrique selon la revendication 11,
**caractérisé en ce que**
l'accumulateur de chaleur (15) est réalisé comme une plaque accumulatrice de chaleur (16) qui est assemblée aux premiers fils (24) au moyen d'un agent adhérent (17) thermiquement conducteur.

13. Dispositif thermoélectrique selon la revendication 11 ou 12,
**caractérisé en ce que**
l'accumulateur de chaleur (15) présente un matériau mécaniquement souple.

14. Dispositif thermoélectrique selon l'une quelconque des revendications 11 à 13,
**caractérisé en ce que**
l'accumulateur de chaleur (15) présente une enveloppe souple (18), de préférence en un métal, de manière de loin préférée une feuille métallique, dans laquelle un liquide (19) ou un matériau à changement de phase MCP (20) est agencé en vue du stockage temporaire de la chaleur.

15. Dispositif thermoélectrique selon l'une quelconque des revendications 5 à 14,
**caractérisé en ce que**
une épaisseur de gaine de la gaine (14) électriquement isolante d'au moins un premier fil (24) dans au moins une zone de transition (26) entre un tronçon de fil (5, 6) dopé p ou n et le tronçon de fil voisin (8) non dopé est augmentée en vue du soulagement de traction.

16. Dispositif thermoélectrique selon l'une quelconque des revendications précédentes,
**caractérisé en ce que**,
dans au moins une zone de transition (26) d'un premier fil (24) entre un tronçon de fil (5, 6) dopé p ou n et le tronçon de fil voisin (8) d'au moins un premier fil (24), il est prévu une enveloppe (27), en particulier supplémentaire, en vue du soulagement de traction.

17. Installation de climatisation avec au moins un dispositif thermoélectrique (1) selon l'une quelconque des revendications précédentes.
